# EUROPÄISCHE PATENTANMELDUNG

(11) **EP 4 106 182 A1**
(43) Veröffentlichungstag der Anmeldung: **21.12.2022**
(21) Anmeldenummer: 21179858.2
(22) Anmeldetag: 16.06.2021
(51) Int. Cl.: H02P 23/14, H02P 29/60

(54) **VERFAHREN UND MASCHINENSTEUERUNG ZUR TEMPERATURÜBERWACHUNG EINER ELEKTROMECHANISCHEN MASCHINE**

(71) Anmelder: Siemens Aktiengesellschaft, 80333 München (DE)
(72) Erfinder: Amschler, Benjamin, 95500 Heinersreuth (DE); Khalil, Mohamed, 81379 München (DE); Malik, Vincent, 80636 München (DE); Paffrath, Meinhard, 85622 Feldkirchen (DE); Wolf Pozzo, Christian Andreas, 90513 Zirndorf (DE)

(57) **Zusammenfassung**

Zur Temperaturüberwachung einer elektromechanischen Maschine (M) anhand von elektrischen Betriebsdaten (U, I RPM) der Maschine (M) werden Strukturdaten (SD) über eine Geometrie, eine Wärmeleitfähigkeit und eine elektrische Leitfähigkeit von Elementen der Maschine (M) eingelesen. Anhand der Strukturdaten (SD) und der elektrischen Betriebsdaten (U, I) werden fortlaufend elektrische Energieverluste (QE) in der Maschine (M) mittels eines elektrischen Simulationsmodells (SE) der Maschine (M) ortsaufgelöst simuliert. Weiterhin wird anhand der Strukturdaten (SD) und der simulierten elektrischen Energieverluste (QE) fortlaufend eine Temperaturverteilung (TD) in der Maschine (M) mittels eines thermischen Simulationsmodells (ST) der Maschine (M) simuliert. Gemäß der simulierten Temperaturverteilung (TD) wird dann ein Temperaturwert (T1-T3) für eine Komponente (C1-C3) der Maschine ermittelt und zu deren Temperaturüberwachung ausgegeben.

## Beschreibung

Ein Betrieb von elektromechanischen Maschinen, wie beispielsweise Elektromotoren, erfordert insbesondere im Bereich höherer Leistungen in vielen Fällen eine Temperaturüberwachung von kritischen Maschinenkomponenten. Die Temperaturen vieler Maschinenkomponenten können jedoch nicht oder nur schwer direkt gemessen werden. So ist es in der Regel technisch sehr aufwändig, Temperatursensoren an einem Rotor eines Motors zu installieren und Sensorsignale von dort zu einer Überwachungseinrichtung zu transportieren.

Um dennoch zumindest Abschätzungen über zu erwartende Betriebstemperaturen zu erhalten, werden häufig historische Betriebsdaten einer Maschine verwendet. Zu diesem Zweck werden aber in der Regel große Mengen von historischen Betriebsdaten für die betreffende Maschine benötigt, die eine Vielzahl von Betriebsbedingungen abdecken.

Es ist weiterhin bekannt, Messwerte von Temperatursensoren auszuwerten, die an leichter zugänglichen Stellen der zu überwachenden Maschine angebracht sind. Anhand dieser Messwerte kann dann mit Hilfe von physikalischen Simulationsmodellen auf die Temperaturen von weniger zugänglichen Maschinenkomponenten rückgeschlossen werden.

Es ist Aufgabe der vorliegenden Erfindung, ein Verfahren und eine Maschinensteuerung zur Temperaturüberwachung einer elektromechanischen Maschine anzugeben, die eine effizientere und/oder weniger aufwändige Temperaturüberwachung erlauben.

Gelöst wird diese Aufgabe durch ein Verfahren mit den Merkmalen des Patentanspruchs 1, durch eine Maschinensteuerung mit den Merkmalen des Patenanspruchs 10, durch ein Computerprogrammprodukt mit den Merkmalen des Patenanspruchs 11 sowie durch ein computerlesbares Speichermedium mit den Merkmalen des Patentanspruchs 12.

Zur Temperaturüberwachung einer elektromechanischen Maschine anhand von elektrischen Betriebsdaten der Maschine werden Strukturdaten über eine Geometrie, eine Wärmeleitfähigkeit und eine elektrische Leitfähigkeit von Elementen der Maschine eingelesen. Anhand der Strukturdaten und der elektrischen Betriebsdaten werden fortlaufend elektrische Energieverluste in der Maschine mittels eines elektrischen Simulationsmodells der Maschine ortsaufgelöst simuliert. Weiterhin wird anhand der Strukturdaten und der simulierten elektrischen Energieverluste fortlaufend eine Temperaturverteilung in der Maschine mittels eines thermischen Simulationsmodells der Maschine simuliert. Gemäß der simulierten Temperaturverteilung wird dann ein Temperaturwert für eine Komponente der Maschine ermittelt und zu deren Temperaturüberwachung ausgegeben.

Zum Ausführen des erfindungsgemäßen Verfahrens sind eine Maschinensteuerung, ein Computerprogrammprodukt sowie ein computerlesbares, vorzugsweise nichtflüchtiges Speichermedium vorgesehen.

Das erfindungsgemäße Verfahren sowie die erfindungsgemäße Maschinensteuerung können beispielsweise mittels eines oder mehrerer Computer, Prozessoren, anwendungsspezifischer integrierter Schaltungen (ASIC), digitaler Signalprozessoren (DSP) und/oder sogenannter "Field Programmable Gate Arrays" (FPGA) ausgeführt bzw. implementiert werden.

Ein Vorteil der Erfindung ist insbesondere darin zu sehen, dass Temperaturen von Maschinenkomponenten anhand von Betriebsdaten ermittelt werden können, die häufig in einer Maschinensteuerung ohnehin vorliegen. Eine Installation von Temperatursensoren an oder in der Maschine selbst ist daher in vielen Fällen nicht mehr erforderlich. Darüber hinaus können mittels der Simulationen auch Temperaturen für schwer zugängliche Maschinenkomponenten, insbesondere im Inneren der Maschine ermittelt und/oder überwacht werden.

Vorteilhafte Ausführungsformen und Weiterbildungen der Erfindung sind in den abhängigen Ansprüchen angegeben.

Gemäß einer vorteilhaften Ausführungsform der Erfindung können anhand der Strukturdaten und mechanischen Betriebsdaten der Maschine mechanische Energieverluste in der Maschine mittels eines mechanischen Simulationsmodells der Maschine ortsaufgelöst simuliert werden. Die Simulation der Temperaturverteilung kann dann anhand der simulierten mechanischen Energieverluste durchgeführt werden. Das mechanische Simulationsmodell kann dabei insbesondere Reibungsverluste, z.B. in Achslagern der Maschine simulieren. Zu diesem Zweck können die Strukturdaten Reibungskoeffizienten für die von Reibungsverlusten betroffenen Maschinenelementen umfassen.

Weiterhin können die mechanischen Betriebsdaten eine Drehzahl, ein Drehmoment, eine Bewegungsgeschwindigkeit und/oder eine ausgeübte Kraft der Maschine oder einer Komponente davon quantifizieren. Ferner können die elektrischen Betriebsdaten insbesondere einen Betriebsstrom und/oder eine Betriebsspannung der Maschine oder einer Komponente davon quantifizieren. Die vorgenannten Betriebsdaten liegen in vielen Maschinensteuerungen ohnehin vor, so dass zur Temperaturüberwachung der Maschine häufig keine zusätzlichen Installationen an oder in der zu überwachenden Maschine erforderlich sind.

Nach einer vorteilhaften Weiterbildung der Erfindung können Strukturdaten über die elektrische Leitfähigkeit und/oder die Wärmeleitfähigkeit der Maschinenelemente abhängig von der simulierten Temperaturverteilung modifiziert werden. Eine Simulation der elektrischen Energieverluste und/oder der Temperaturverteilung kann dann anhand der modifizierten Strukturdaten durchgeführt werden. Damit kann insbesondere eine Temperaturabhängigkeit von elektrischen Widerständen bei einer Simulation der elektrischen Energieverluste und/oder eine Temperaturabhängigkeit einer Wärmeleitfähigkeit bei einer Simulation der Temperaturverteilung berücksichtigt werden. Auf diese Weise kann eine Simulationsgenauigkeit in der Regel signifikant erhöht werden.

Weiterhin kann abhängig vom ermittelten Temperaturwert die Maschine heruntergeregelt, eine Angabe über einen optimierten Betrieb der Maschine ausgegeben und/oder eine Kühlungseinrichtung angesteuert werden. Durch die vorstehenden Maßnahmen kann in vielen Fällen ein Verschleiß der Maschine erheblich verringert und/oder ihre Lebensdauer erhöht werden.

Nach einer vorteilhaften Ausführungsform der Erfindung kann zumindest eine der Simulationen mittels eines datengetriebenen Surrogat-Modells ausgeführt werden. Als Surrogat-Modell kann insbesondere ein künstliches neuronales Netz oder ein anderes Maschinenlernmodell eingesetzt werden. Ein jeweiliges Surrogat-Modell kann vorab, z.B. mittels eines physikalischen Simulationsmodells darauf trainiert werden, dessen Simulationsergebnisse zu prädizieren. Mittels eines jeweiligen trainierten Surrogat-Modells kann dann eine jeweilige Simulation in der Regel mit erheblich geringerem Rechenaufwand, insbesondere in Echtzeit, ausgeführt werden.

Nach einer weiteren vorteilhaften Ausführungsform der Erfindung kann für mehrere vorgegebene Maschinenkomponenten anhand der Strukturdaten jeweils eine Position einer jeweiligen Maschinenkomponente ermittelt werden. Anhand der jeweils ermittelten Position und der Temperaturverteilung kann dann jeweils ein komponentenspezifischer Temperaturwert ausgegeben werden. Auf diese Weise können mehrere kritische Maschinenkomponenten, z.B. ein Rotor, ein Stator, eine Wicklung, ein Achslager und/oder eine Isolierung eines Elektromotors individuell überwacht werden.

Nach einer weiteren vorteilhaften Weiterbildung der Erfindung kann eine Temperatur der Maschine an einer Messstelle gemessen werden. Anhand der simulierten Temperaturverteilung kann eine simulierte Temperatur an der Messtelle sowie deren Abweichung von der gemessenen Temperatur ermittelt werden. Damit können eines oder mehrere der Simulationsmodelle darauf trainiert werden, die Abweichung zu minimieren. Auf diese Weise können die Simulationsmodelle im Testbetrieb, bei einer Inbetriebnahme und/oder in regelmäßigen Abständen des laufenden Betriebs der Maschine kalibriert werden, um so die Genauigkeit der Temperaturermittlung zu erhöhen.

Ein Ausführungsbeispiel der Erfindung wird nachfolgend anhand der Zeichnung näher erläutert. Dabei veranschaulichen jeweils in schematischer Darstellung:
- Figur 1: eine Temperaturüberwachung eines Elektromotors durch eine erfindungsgemäße Motorsteuerung und
- Figur 2: eine Kalibrierung einer erfindungsgemäßen Motorsteuerung.

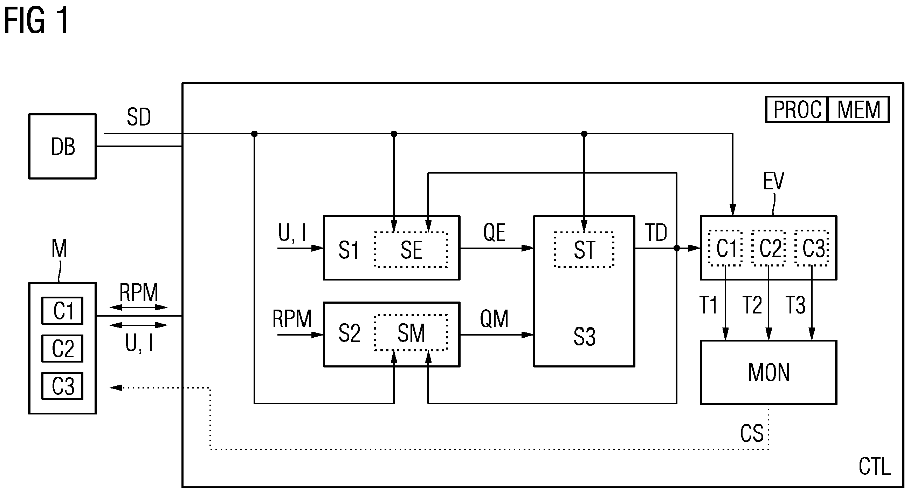

Figur 1 veranschaulicht eine Temperaturüberwachung eines Elektromotors M als elektromechanische Maschine durch eine erfindungsgemäße Motorsteuerung CTL als erfindungsgemäße Maschinensteuerung. Alternativ kann die zu überwachende elektromechanische Maschine M auch ein Roboter, eine Werkzeugmaschine, eine Turbine, eine Produktionsmaschine, ein Kraftfahrzeug, ein 3-D-Drucker oder eine Komponente davon sein oder derartige Maschinen oder Komponenten umfassen. Die Motorsteuerung CTL kann insbesondere einen Inverter umfassen.

Darüber hinaus verfügt die Motorsteuerung CTL über einen oder mehrere Prozessoren PROC zum Ausführen eines erfindungsgemäßen Verfahrens sowie über einen oder mehrere Speicher MEM zum Speichern von zu verarbeitenden Daten.

In Figur 1 ist die Maschinensteuerung CTL extern zur elektromechanischen Maschine M dargestellt und an diese gekoppelt. Alternativ dazu kann die Maschinensteuerung CTL auch ganz oder teilweise in die elektromechanische Maschine M integriert sein.

Die Motorsteuerung CTL dient zum Betreiben und Steuern des Elektromotors M. Zu diesem Zweck kann die Motorsteuerung CTL insbesondere eine Motordrehzahl RPM für den Elektromotor M vorgeben und/oder den Elektromotor M mit einer entsprechenden Betriebsspannung U und/oder einem entsprechenden Betriebsstrom I versorgen. Die Energieversorgung des Elektromotors M kann dabei insbesondere durch einen Inverter (nicht dargestellt) der Motorsteuerung CTL erfolgen. Darüber hinaus kann die Motorsteuerung CTL von Sensoren des Elektromotors M aktuell gemessene Motordrehzahlen RPM, Betriebsspannungen U und/oder Betriebsströme I erfassen. Aus Übersichtlichkeitsgründen sind gemessene und vorgegebene Betriebsdaten in den Figuren jeweils durch das gleiche Bezugszeichen bezeichnet.

Alternativ oder zusätzlich zu den Motordrehzahlen RPM können durch die Maschinensteuerung CTL weitere mechanische Betriebsdaten der elektromechanischen Maschine M erfasst oder verwendet werden, zum Beispiel ein Drehmoment, eine Bewegungsgeschwindigkeit und/oder eine ausgeübte Kraft der Maschine M oder einer Komponente davon. Entsprechend können neben den Betriebsspannungen U oder den Betriebsströmen I weitere aktuelle elektrische Betriebsdaten der elektromechanischen Maschine M oder einer Komponente davon durch die Maschinensteuerung CTL erfasst oder verwendet werden.

Für das vorliegende Ausführungsbeispiel sei angenommen, dass die Maschine M drei Maschinenkomponenten C1, C2 und C3 aufweist, deren Temperatur komponentenspezifisch zu überwachen ist. Im Falle eines Elektromotors kann eine jeweilige zu überwachende Maschinenkomponente insbesondere ein Rotor, ein Stator, eine Wicklung, ein Achslager oder eine Isolierung des Elektromotors sein.

Die Maschinensteuerung CTL ist weiterhin an eine Datenbank DB gekoppelt, in der Strukturdaten SD über eine Geometrie, eine Wärmeleitfähigkeit und eine elektrische Leitfähigkeit von Elementen der Maschine M gespeichert sind. Eine Wärmeleitfähigkeit kann dabei äquivalent durch einen Wärmewiderstand und eine elektrische Leitfähigkeit durch einen elektrischen Widerstand ausgedrückt oder dargestellt werden.

Darüber hinaus umfassen die Strukturdaten SD Reibungskoeffizienten für von Reibungsverlusten betroffene Elemente der Maschine M. Dies können insbesondere Reibungskoeffizienten für eine Reibung zwischen einer Rotorachse und einem Achslager sein.

Beispiele für die durch die Strukturdaten SD beschriebenen Maschinenelemente sind insbesondere die Maschinenkomponenten C1, C2 und C3 oder Teile davon sowie Teile der Maschine M mit spezifischem Einfluss auf eine elektrische Leitung, eine Wärmeleitung und/oder eine Reibung beim Betrieb der Maschine M. Dies können beispielsweise Beschichtungen, elektrische Leitungen, Schaltelemente, Wärmebrücken oder andere Konstruktionselemente der Maschine M sein. Die Strukturdaten SD spezifizieren die Wärmeleitfähigkeit, die elektrische Leitfähigkeit und/oder eine Reibung vorzugsweise in ortsaufgelöster Form.

Die Maschinensteuerung CTL umfasst ein erstes Simulationsmodul S1 mit einem elektrischen Simulationsmodell SE der Maschine M, ein zweites Simulationsmodul S2 mit einem mechanischen Simulationsmodell SM der Maschine M sowie ein drittes Simulationsmodul S3 mit einem thermischen Simulationsmodell ST der Maschine M.

Das erste Simulationsmodul S1 dient zum fortlaufenden orts- und zeitaufgelösten Simulieren von elektrischen Energieverlusten QE in der Maschine M anhand des elektrischen Simulationsmodells SE. Das zweite Simulationsmodul S2 dient zum fortlaufenden orts- und zeitaufgelösten Simulieren von mechanischen Energieverlusten QM in der Maschine M mittels des mechanischen Simulationsmodells SM. Schließlich dient das dritte Simulationsmodul S3 zum fortlaufenden orts- und zeitaufgelösten Simulieren einer sich einstellenden Temperaturverteilung TD in der Maschine M anhand des thermischen Simulationsmodells ST. Das elektrische Simulationsmodell SE und das mechanische Simulationsmodel SM können dabei ggf. zu einem elektromechanischen Simulationsmodell kombiniert werden. Durch die Simulationsmodule S1, S2 und S3 wird jeweils eine im Betrieb der Maschine M mitlaufende Echtzeit-Simulation ausgeführt.

Zur Initialisierung der Simulationsmodelle SE, SM und ST speist die Maschinensteuerung CTL die eingelesenen Strukturdaten SD zumindest teilweise in die Simulationsmodule S1, S2 und S3 ein. Infolgedessen wird das elektrische Simulationsmodell SE durch Strukturdaten SD über die Geometrie und die elektrische Leitfähigkeit von Maschinenelementen initialisiert. Analog dazu wird das mechanische Simulationsmodell SM durch Strukturdaten SD über die Geometrie und die Reibung von Maschinenelementen initialisiert. Schließlich wird das thermische Simulationsmodell ST durch Strukturdaten SD über die Geometrie und die Wärmeleitfähigkeit von Maschinenelementen initialisiert.

Zur Ausführung der vorstehenden Simulationen sind viele effiziente Verfahren und Modelle zur physikalischen Simulation verfügbar. Insbesondere können finite-Elemente-Verfahren oder effiziente Surrogat-Modelle zur Simulation verwendet werden. Unter einem Surrogat-Modell sei hierbei insbesondere ein gegenüber einer detaillierten physikalischen Simulation vereinfachtes oder zumindest weniger Rechenressourcen beanspruchendes Verfahren verstanden, das die gewünschten Simulationsergebnisse möglichst genau reproduziert. Als Surrogat-Modell kann insbesondere ein neuronales Netz oder ein anderes Maschinenlernmodell verwendet werden, das vorab mittels eines detaillierten physikalischen Simulationsmodells darauf trainiert wurde, dessen Simulationsergebnisse zu prädizieren. Nach dem Training kann ein solches datengetriebenes Surrogat-Modell gegenüber dem detaillierten physikalischen Simulationsmodell in der Regel erheblich schneller ausgewertet und insbesondere in Echtzeit betrieben werden.

Nach der Initialisierung der Simulationsmodelle SE, SM und ST können die beschriebenen Simulationen anhand der aktuellen Betriebsdaten, hier U, I und RPM der Maschine M in Echtzeit ausgeführt werden. Zu diesem Zweck werden die aktuellen elektrischen Betriebsdaten, hier die Betriebsspannung U und der Betriebsstrom I, fortlaufend in das erste Simulationsmodul S1 eingespeist. Das erste Simulationsmodul S1 simuliert dann anhand der elektrischen Betriebsdaten U und I mittels des initialisierten elektrischen Simulationsmodells SE fortlaufend die elektrischen Energieverluste QE in der Maschine M in orts- und zeitaufgelöster Form. Die simulierten elektrischen Energieverluste QE werden durch das erste Simulationsmodul S1 in das dritte Simulationsmodul S3 eingespeist.

Weiterhin werden die aktuellen mechanischen Betriebsdaten, hier die aktuelle Drehzahl RPM, fortlaufend in das zweite Simulationsmodul S2 eingespeist. Das zweite Simulationsmodul S2 simuliert damit anhand der mechanischen Betriebsdaten RPM mittels des initialisierten mechanischen Simulationsmodells SM fortlaufend die mechanischen Energieverluste QM in der Maschine M in orts- und zeitaufgelöster Form. Die simulierten mechanischen Energieverluste QM werden durch das zweite Simulationsmodul S2 in das dritte Simulationsmodul S3 eingespeist.

Das dritte Simulationsmodul S3 simuliert schließlich anhand der simulierten Energieverluste QE und QM mittels des initialisierten thermischen Simulationsmodells ST fortlaufend die Temperaturverteilung TD in der Maschine M in orts- und zeitaufgelöster Form.

Vorzugsweise kann die simulierte Temperaturverteilung TD zu den Simulationsmodellen SE, SM und ST rückgeführt werden, um die den Modellen SE, SM und ST zugrundeliegenden Strukturdaten SD zu modifizieren. Auf diese Weise können im elektrischen Simulationsmodell SE temperaturabhängige elektrische Widerstände, im thermischen Simulationsmodell ST temperaturabhängige Wärmewiderstände und/oder im mechanischen Simulationsmodell SM temperaturabhängige mechanische Eigenschaften von Maschinenelementen berücksichtigt werden. Damit kann in vielen Fällen eine Genauigkeit der Simulationen signifikant erhöht werden.

Die simulierte Temperaturverteilung TD wird vom dritten Simulationsmodul S3 fortlaufend in ein Auswertungsmodul EV der Maschinensteuerung CTL eingespeist. Zur Initialisierung des Auswertungsmoduls EV wurden bereits vorab Strukturdaten SD über die Geometrie der Maschinenelemente zum Auswertungsmodul EV übermittelt. Die übermittelten Strukturdaten SD geben dabei insbesondere die räumlichen Positionen der Maschinenkomponenten C1, C2 und C3 in der Maschine M an.

Das Auswertungsmodul EV wertet die orts- und zeitaufgelöste Temperaturverteilung TD fortlaufend an einer jeweiligen Position der Maschinenkomponenten C1, C2 bzw. C3 aus. Dabei wird ein jeweiliger komponentenspezifischer Temperaturwert T1, T2 bzw. T3 an der jeweiligen Position der jeweiligen Maschinenkomponente C1, C2 bzw. C3 ermittelt.

Die Temperaturwerte T1, T2 und T3 werden vom Auswertungsmodul EV zu einem Überwachungsmodul MON der Maschinensteuerung CTL übermittelt. Das Überwachungsmodul MON prüft anhand der übermittelten komponentenspezifischen Temperaturwerte T1, T2 und T3 fortlaufend, ob eine zulässige Höchsttemperatur einer jeweiligen Komponente C1, C2 bzw. C3 überschritten und/oder eine jeweilige Solltemperatur eingehalten wird. Dies kann beispielsweise durch Vergleich mit vorgegebenen Schwellwerten und/oder mit vorgegebenen Temperaturintervallen erfolgen.

In Abhängigkeit von diesen Prüfungen kann durch das Überwachungsmodul MON die Maschine M heruntergeregelt, eine Kühleinrichtung der Maschine M angesteuert und/oder eine Angabe oder eine Empfehlung für einen optimierten Betrieb der Maschine M ausgegeben werden. Zu einer entsprechenden Ansteuerung der Maschine M wird durch das Überwachungsmodul MON ein geeignetes Steuersignal CS gebildet und - wie in Figur 1 durch einen punktierten Pfeil angedeutet - zur Maschine M übermittelt.

Die Erfindung erlaubt eine effiziente und genaue Temperaturüberwachung der Maschine bzw. des Motors M anhand von aktuell gemessenen oder durch die Maschinensteuerung CTL vorgegebenen Betriebsdaten, hier U, I, RPM, die in vielen Maschinensteuerungen, Motorsteuerungen oder Invertern ohnehin vorliegen. Auf diese Weise kann eine Temperaturüberwachung implementiert werden, die in vielen Fällen ohne aufwändige am oder im Motor anzubringende Sensoren auskommt.

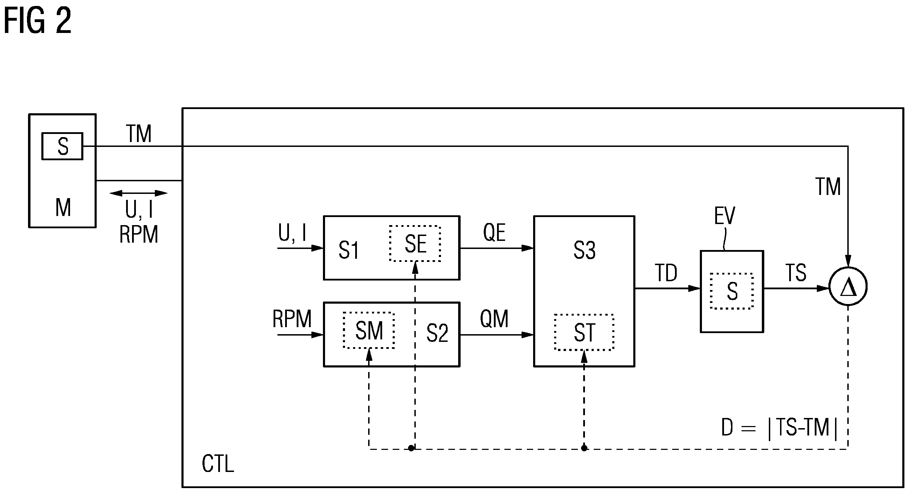

Figur 2 veranschaulicht eine Kalibrierung der Motorsteuerung CTL durch Kalibrierung ihrer Simulationsmodelle SE, SM und/oder ST. Insofern in Figur 2 die gleichen oder korrespondierenden Bezugszeichen wie in Figur 1 verwendet werden, bezeichnen diese Bezugszeichen die gleichen oder korrespondierenden Entitäten, die insbesondere wie oben beschrieben, implementiert oder ausgestaltet sein können. Einige der in Figur 1 dargestellten Komponenten und Datenflüsse der Maschinensteuerung CTL und der Maschine M sind in Figur 2 aus Übersichtlichkeitsgründen nicht mehr explizit dargestellt.

Zur Kalibrierung eines jeweiligen Simulationsmodells SE, SM bzw. ST wird eine von einem Temperatursensor S der Maschine M gemessene Temperatur TM durch die Maschinensteuerung CTL erfasst. Der Temperatursensor S ist vorzugsweise an einer leicht zugänglichen Messstelle an einer Außenseite der Maschinensteuerung CTL angebracht. Die gemessene Temperatur TM gibt mithin die Temperatur der Maschine M an der Messstelle wieder.

Weiterhin wird durch die Maschinensteuerung CTL, wie oben beschrieben, anhand der vorgegebenen Strukturdaten SD sowie anhand der aktuellen Betriebsdaten U, I und RPM mittels der Simulationsmodule S1, S2 und S3 eine Temperaturverteilung TD simuliert und an das Auswertungsmodul EV übermittelt. Letzteres wertet die Temperaturverteilung TD an der durch die Strukturdaten SD vorgegebenen Position des Sensors S aus und ermittelt so eine simulierte Temperatur TS an der Messstelle. Darüber hinaus wird eine Abweichung D zwischen der simulierten Temperatur TS und der gemessenen Temperatur TM ermittelt, zum Beispiel als Betrag oder Quadrat einer Differenz TS-TM. Die Abweichung D wird - wie in Figur 2 durch strichlierte Pfeile angedeutet - zu den Simulationsmodellen SE, SM und/oder ST zurückgeführt, um diese darauf zu trainieren, die Abweichung D zu minimieren. Unter einem Training sei hierbei verstanden, Simulationsparameter der betreffenden Simulationsmodelle SE, SM bzw. ST so zu modifizieren, dass resultierende Abweichungen D minimiert werden. Für derartige Minimierungsprobleme steht eine Vielzahl effizienter Optimierungsverfahren, insbesondere des maschinellen Lernens, zur Verfügung.

Durch eine solche Kalibrierung kann eine Genauigkeit der Temperaturermittlung in vielen Fällen wesentlich erhöht werden. Die Kalibrierung kann insbesondere im Testbetrieb, bei einer Inbetriebnahme oder in regelmäßigen Abständen des laufenden Betriebs der Maschine M durchgeführt werden.

## Patentansprüche

1. Computerimplementiertes Verfahren zur Temperaturüberwachung einer elektromechanischen Maschine (M) anhand von elektrischen Betriebsdaten (U, I) der Maschine (M), wobei
a) Strukturdaten (SD) über eine Geometrie, eine Wärmeleitfähigkeit und eine elektrische Leitfähigkeit von Elementen der Maschine eingelesen werden,
b) anhand der Strukturdaten (SD) und der elektrischen Betriebsdaten (U, I) fortlaufend elektrische Energieverluste (QE) in der Maschine (M) mittels eines elektrischen Simulationsmodells (SE) der Maschine (M) ortsaufgelöst simuliert werden,
c) anhand der Strukturdaten (SD) und der simulierten elektrischen Energieverluste (QE) fortlaufend eine Temperaturverteilung (TD) in der Maschine mittels eines thermischen Simulationsmodells (ST) der Maschine simuliert wird, und
d) gemäß der simulierten Temperaturverteilung (TD) ein Temperaturwert (T1-T3) für eine Komponente (C1-C3) der Maschine ermittelt und zu deren Temperaturüberwachung ausgegeben wird.

2. Verfahren nach Anspruch 1, **dadurch gekennzeichnet,**
**dass** anhand der Strukturdaten (SD) und mechanischen Betriebsdaten (RPM) der Maschine (M) mechanische Energieverluste (QM) in der Maschine mittels eines mechanischen Simulationsmodells (SM) der Maschine ortsaufgelöst simuliert werden, und
**dass** die Simulation der Temperaturverteilung (TD) anhand der simulierten mechanischen Energieverluste (QM) durchgeführt wird.

3. Verfahren nach einem der vorhergehenden Ansprüche, **dadurch gekennzeichnet,**
**dass** durch die mechanischen Betriebsdaten (RPM) eine Drehzahl, ein Drehmoment, eine Bewegungsgeschwindigkeit und/oder eine ausgeübte Kraft der Maschine (M) quantifiziert wird.

4. Verfahren nach einem der vorhergehenden Ansprüche, **dadurch gekennzeichnet,**
**dass** durch die elektrischen Betriebsdaten (I, U) ein Betriebsstrom und/oder eine Betriebsspannung der Maschine (M) quantifiziert wird.

5. Verfahren nach einem der vorhergehenden Ansprüche, **dadurch gekennzeichnet,**
**dass** Strukturdaten (SD) über die elektrische Leitfähigkeit und/oder die Wärmeleitfähigkeit der Maschinenelemente abhängig von der simulierten Temperaturverteilung (TD) modifiziert werden, und
**dass** eine Simulation der elektrischen Energieverluste (QE) und/oder der Temperaturverteilung (TD) anhand der modifizierten Strukturdaten durchgeführt wird.

6. Verfahren nach einem der vorhergehenden Ansprüche, **dadurch gekennzeichnet,**
**dass** abhängig vom Temperaturwert (T1-T3)
- die Maschine (M) heruntergeregelt wird,
- eine Angabe über einen optimierten Betrieb der Maschine (M) ausgegeben wird, und/oder
- eine Kühlungseinrichtung angesteuert wird.

7. Verfahren nach einem der vorhergehenden Ansprüche, **dadurch gekennzeichnet,**
**dass** zumindest eine der Simulationen mittels eines datengetriebenen Surrogat-Modells ausgeführt wird.

8. Verfahren nach einem der vorhergehenden Ansprüche, **dadurch gekennzeichnet,**
**dass** für mehrere vorgegebene Maschinenkomponenten (C1-C3) anhand der Strukturdaten (SD) jeweils eine Position einer jeweiligen Maschinenkomponente (C1-C3) ermittelt wird, und dass anhand der jeweils ermittelten Position und der Temperaturverteilung (TD) jeweils ein komponentenspezifischer Temperaturwert (T1-T3) ausgegeben wird.

9. Verfahren nach einem der vorhergehenden Ansprüche, **dadurch gekennzeichnet,**
**dass** eine Temperatur (TM) der Maschine (M) an einer Messstelle gemessen wird,
**dass** anhand der simulierten Temperaturverteilung (TD) eine simulierte Temperatur (TS) an der Messtelle sowie deren Abweichung (D) von der gemessenen Temperatur (TM) ermittelt werden, und
**dass** zumindest eines der Simulationsmodelle (SE, SM, ST) darauf trainiert wird, die Abweichung (D) zu minimieren.

10. Maschinensteuerung (CTL) zum Betrieb und zur Temperaturüberwachung einer elektromechanischen Maschine (M), eingerichtet zum Ausführen eines Verfahrens nach einem der vorhergehenden Ansprüche.

11. Computerprogrammprodukt eingerichtet zum Ausführen eines Verfahrens nach einem der Ansprüche 1 bis 9.

12. Computerlesbares Speichermedium mit einem Computerprogrammprodukt nach Anspruch 11.
